Europäisches Patentamt

European Patent Office

Office européen des brevets

(19)

(11) **EP 0 834 216 B1**

(12) **FASCICULE DE BREVET EUROPEEN**

(45) Date de publication et mention
de la délivrance du brevet:
**08.12.1999 Bulletin 1999/49**

(21) Numéro de dépôt: **96922952.5**

(22) Date de dépôt: **19.06.1996**

(51) Int Cl.6: **H03D 3/00**, G01N 27/90

(86) Numéro de dépôt international:
**PCT/FR96/00947**

(87) Numéro de publication internationale:
**WO 97/01217 (09.01.1997 Gazette 1997/03)**

(54) **DISPOSITIF DE DEMODULATION SIMULTANEE D'UN SIGNAL MULTIFREQUENTIEL, NOTAMMENT POUR UNE MESURE PAR COURANTS DE FOUCAULT**

VORRICHTUNG ZUR GLEICHZEITIGEN DEMODULATION EINES MEHRFREQUENZSIGNALS, INSBESONDERE FÜR EINE MESSUNG DURCH WIRBELSTÜRME

DEVICE FOR SIMULTANEOUSLY DEMODULATING A MULTIFREQUENCY SIGNAL, IN PARTICULAR FOR AN EDDY CURRENT MEASUREMENT

(84) Etats contractants désignés:
**BE CH DE DK ES GB IT LI NL SE**

(30) Priorité: **20.06.1995 FR 9507357**

(43) Date de publication de la demande:
**08.04.1998 Bulletin 1998/15**

(73) Titulaire: **INTERCONTROLE Société Anonyme
94583 Rungis Cédex (FR)**

(72) Inventeur: **DE LEDINGHEN, Edouard
F-78000 Versailles (FR)**

(74) Mandataire: **Dubois-Chabert, Guy et al
BREVATOME
3, rue du Docteur Lanceraux
75008 Paris (FR)**

(56) Documents cités:
**WO-A-90/04292         DE-A- 3 435 032
US-A- 4 303 885         US-A- 4 467 281**

## Description

Domaine technique

La présente invention telle qu'elle est définie dans les revendications concerne un dispositif de démodulation simultanée d'un signal multifréquentiel, notamment pour une mesure par courants de Foucault.

Etat de la technique antérieure

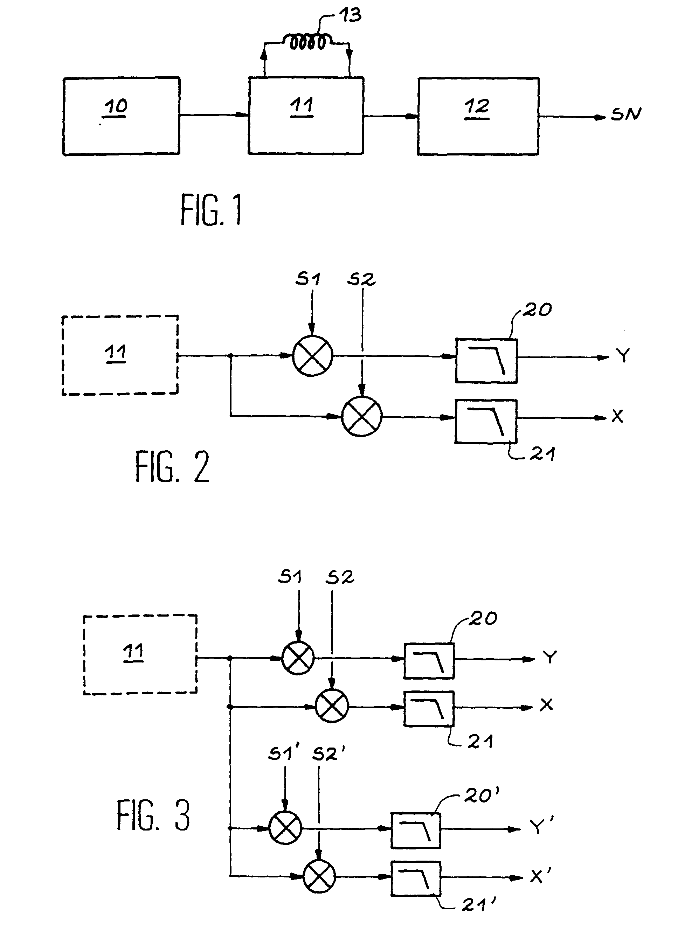

Le synoptique d'un appareil de mesure par courants de Foucault, illustré sur la figure 1, comprend un oscillateur-équilibreur 10, un injecteur 11 et un démodulateur 12 délivrant une sortie numérique SN.

Le document US-A-4 467 281 divulgue un appareil de mesure par courant de Foucault.

L'oscillateur a pour fonction de produire un signal multifréquence sur la base d'une somme de 1 à N sinusoïdes pures. L'équilibreur a pour fonction de diminuer l'influence des porteuses pour amplifier relativement le signal modulant (signal courants de Foucault). L'injecteur 11 a pour fonction d'alimenter un capteur 13 dans laquelle s'effectue la modulation par courants de Foucault. Le démodulateur 12 a pour fonction d'extraire le signal modulant (modulation par courants de Foucault) des porteuses utilisées.

Dans un tel appareil, les données techniques sont généralement les suivantes :

- les porteuses sinusoïdales ont une fréquence comprise entre 1 kHz et 4 MHz ;
- un appareil de mesure utilise couramment entre une et quatre porteuses simultanément ;
- la bande passante des signaux courants de Foucault ne dépasse pas 1 kHz ;
- la modulation par courants de Foucault est une modulation complexe : amplitude et phase ;
- le démodulateur a pour mission d'extraire ces deux informations pour chacune des porteuses. Il extrait sous forme cartésienne le signal modulé dans le capteur ayant l'équation suivante : $X\mathrm{co}(wt) + Y\sin(wt)$. Le démodulateur extrait $X$ et $Y$.

Les appareils actuels utilisent, entre autres, deux méthodes de démodulation :

**La démodulation sinusoïdale synchrone**

Le synoptique utilisé est représenté sur la figure 2.

Le signal en provenance de l'injecteur 11 est distribué dans deux canaux identiques : dans l'un il est multiplié par une sinusoïde pure S1 à la fréquence de l'une des porteuses utilisées ; dans l'autre, par un signal sinusoïdal S2 à la même fréquence, mais en quadrature de phase avec le premier. Le résultat de ces multiplications a pour effet de transposer le signal de l'injecteur en bande de base. Un filtrage passe-bas (filtres 20, 21) à la fréquence maximale des courants de Foucault (par exemple fc = 500 Hz) permet d'extraire les couples $X,Y$.

Cette méthode de démodulation demande de reproduire le schéma de la figure 2 en autant d'exemplaires qu'il y a de fréquences utilisées simultanément : $f1, f2, fn,$ comme représenté sur la figure 3.

**La démodulation par échantillonnage en quadrature**

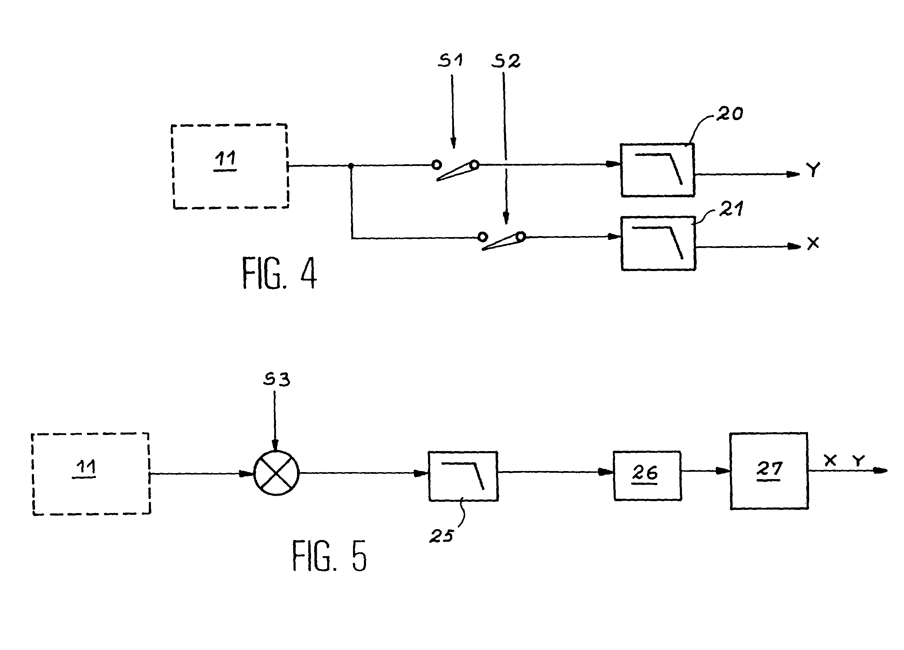

Cette méthode utilise le synoptique illustré sur la figure 4.

Le signal en provenance de l'injecteur 11 est distribué sur deux canaux identiques. Sur l'un, il est connecté au filtre 20 pendant un bref instant de la période de la sinusoïde de la porteuse que l'on cherche à démoduler. Le reste du temps, la tension ainsi échantillonnée est maintenue à l'entrée du filtre. Sur l'autre canal, l'échantillonnage s'effectue à la même fréquence, mais avec 90° de décalage de phase (en quadrature).

De la même manière que précédemment, cette méthode de démodulation demande de reproduire le synoptique illustré sur la figure 4 en autant d'exemplaires qu'il y a de fréquences utilisées simultanément. Par ailleurs, elle ne rejette pas efficacement d'éventuelles harmoniques du signal porteur.

Exposé de l'invention

L'invention concerne un dispositif de démodulation simultanée d'un signal multifréquentiel, qui comprend un processeur dans lequel la démodulation est faite par calcul. Ce dispositif comprend un injecteur dont le signal de sortie est multiplié par un signal complexe qui a la forme suivante :

$$S3 = a_1 \sin\left\{2\pi\left(f_1 + \varepsilon_1\right)t + \varphi_1\right\} + a_2 \sin\left\{2\pi\left(f_2 + \varepsilon_2\right)t + \varphi_2\right\}$$
$$+ \ldots\ldots a_n \sin\left\{2\pi\left(f_n + \varepsilon_n\right)t + \varphi_n\right\}$$

$\varepsilon_l$ étant un écart faible de fréquence et $\varphi_l$ une phase, les fréquences des N sinusoïdes étant les fréquences des porteuses décalées en fréquence, de manière à transposer le signal de l'injection sur les fréquences intermédiaires.

Avantageusement le dispositif comprend un injecteur suivi d'un multiplieur, et d'un filtre passe-bas. Ce filtre ayant une fonction d'anti-repliement, est suivi d'un convertisseur en numérique.

Avantageusement ce dispositif peut être utilisé pour une mesure par courants de Foucault.

Brève description des dessins

- La figure 1 illustre un appareil de mesure par courants de Foucault de l'art connu ;
- les figures 2 et 3 illustrent des dispositifs de démodulation sinusoïdale synchrone de l'art connu ;
- la figure 4 illustre un dispositif de démodulation par échantillonnage en quadrature de l'art connu ;
- la figure 5 représente un dispositif de démodulation permettant de mettre en évidence le procédé de l'invention.

Exposé détaillé de modes de réalisation

L'invention concerne un procédé de démodulation d'un signal multifréquentiel, qui est la somme de plusieurs ondes porteuses modulées en amplitude et en phase. Comme illustré sur la figure 5, le signal en provenance de l'injecteur est multiplié par un signal complexe formé de plusieurs signaux élémentaires, par exemple :

$$S3 = a_1 \sin\left\{2\pi\left(f_1 + \varepsilon_1\right)t + \varphi_1\right\} + a_2 \sin\left\{2\pi\left(f_2 + \varepsilon_2\right)t + \varphi_2\right\}$$
$$+ \ldots\ldots a_n \sin\left\{2\pi\left(f_n + \varepsilon_n\right)t + \varphi_n\right\}.$$

Si N porteuses sont utilisées simultanément, le signal utilisé pour la multiplication est la somme de N sinusoïdes. Les fréquences des N sinusoïdes sont les N fréquences des porteuses, décalées en fréquence, par exemple de quelques kHz. Par exemple, si l'on utilise simultanément les porteuses 100, 240 et 500 kHz, le signal est multiplié par 101, 242.5 et 505 kHz (ces valeurs données à titre d'exemple ne sont pas exclusives).

Ce produit a pour effet de transposer le signal de l'injection 11 sur les fréquences dites intermédiaires. Ces fréquences intermédiaires sont les différences respectives entre la fréquence du signal porteur et la fréquence de l'opérande.

Dans l'exemple ci-dessus ces fréquences intermédiaires valent 1, 2,5 et 5 kHz.

Le filtre passe-bas 25 (fc=10kHz) qui suit a la fonction d'anti-repliement avant la conversion du signal en numérique (convertisseur 26) sur 16 bits à environ 20 kHz (toutes valeurs non exclusives).

Le processeur 27 (Digital Signal Processor) a pour mission de réaliser la démodulation proprement dite, c'est-à-dire de transposer le signal en bande de base. Toute méthode de démodulation numérique peut être utilisée.

L'originalité de cette méthode réside dans le fait que le dispositif de la figure 5 est un démodulateur de N fréquences simultanées. Il n'est pas besoin de dupliquer ce schéma pour démoduler plus de porteuses. Par ailleurs, ce démodulateur peut être aussi insensible aux harmoniques que celui illustré sur la figure 3. La qualité de la démodulation dépend de l'algorithme utilisé dans le processeur 27.

**Revendications**

1.   Dispositif de démodulation simultanée d'un signal multifréquentiel, comprenant un processeur (27) dans lequel la démodulation est faite par calcul, caractérisé en ce qu'il comprend un injecteur (11) dont le signal de sortie est multiplié par un signal complexe ayant la forme suivante :

$$S3 = a_1 \sin\{2\pi(f_1 + \varepsilon_1)t + \varphi_1\} + a_2 \sin\{2\pi(f_2 + \varepsilon_2)t + \varphi_2\}$$
$$+ \ldots\ldots a_n \sin\{2\pi(f_n + \varepsilon_n)t + \varphi_n\}$$

$\varepsilon_l$ étant un écart faible de fréquence, $\varphi_l$ une phase les fréquences des N sinusoïdes étant les fréquences des porteuses décalées en fréquences, de manière à transposer le signal de l'injection sur les fréquences intermédiaires.

2. Dispositif selon la revendication 1, caractérisé en ce qu'il comprend un injecteur (11) suivi d'un multiplieur, d'un filtre passe-bas (25), et en ce que ce filtre (25), ayant une fonction d'anti-repliement, est suivi d'un convertisseur en numérique (26).

3. Procédé utilisant un dispositif selon l'une quelconque des revendications précédentes utilisé pour une mesure par courants de Foucault.

**Patentansprüche**

1. Vorrichtung zur gleichzeitigen Demodulation eines Mehrfrequenzsignals mit einem Prozessor (27), in dem die Demodulation durch Rechnen erfolgt,
**dadurch gekennzeichnet**,
daß sie eine Einspeiseinrichtung (11) umfaßt, deren Ausgangssignal multipliziert wird mit einem komplexen Signal, das folgende Form hat:

$$S3 = a_1 \sin\{2\pi(f_1 + \varepsilon_1)t + \varphi_1\} + a_2 \sin\{2\pi(f_2 + \varepsilon_2)t + \varphi_2\}$$
$$+ \ldots\ldots a_n \sin\{2\pi(f_n + \varepsilon_n)t + \varphi_n\}$$

wobei $\varepsilon_1$ ein kleiner Frequenzabstand und $\varphi_1$ eine Phase ist, wobei die Frequenzen der N Sinuswellen die Frequenzen der frequenzverschobenen Träger sind, um das Signal der Einspeisung umzustellen auf die Zwischenfrequenzen.

2. Vorrichtung nach Anspruch 1, dadurch gekennzeichnet, daß sie eine Einspeiseinrichtung (11), gefolgt von einem Multiplizierer, und ein Tiefpaßfilter (25) umfaßt, und dadurch, daß dieses Filter (25), das eine Anti-Abkapselungsfunktion hat, von einem Digitalwandler bzw. -umsetzer (26) gefolgt wird.

3. Verfahren zur Benutztung einer Vorrichtung nach einem der vorangehenden Ansprüche für eine Messung durch Wirbelstrom.

**Claims**

1. Device for the simultaneous demodulation of a multifrequency signal, comprising a processor (27), where the demodulation takes place by calculation, characterized in that it comprises an injector (11), whose output signal is multiplied by a complex signal in the following form:

$$S3 = a_1 \sin\{2\pi(f_1 + \varepsilon_1)t + \varphi_1\} + a_2 \sin\{2\pi(f_2 + \varepsilon_2)t + \varphi_2\}$$
$$+ \ldots\ldots a_n \sin\{2\pi(f_n + \varepsilon_n)t + \varphi_n\}$$

$\epsilon_1$ being a small frequency deviation and $\varphi_1$ a phase, the frequencies of the N sinusoids being the frequencies of the frequency-shifted carriers, so as to transpose the signal of the injection on the intermediate frequencies.

2. Device according to claim 1, characterized in that it comprises an injector (11) followed by a multiplier and a low-pass filter (25), and in that said filter (25), having an anti-aliasing function, is followed by a digital converter (26).

3. Method using a device according to either of the preceding claims for an eddy current measurement.

FIG. 1

FIG. 2

FIG. 3

EP 0 834 216 B1

S1   S2

20

11

Y

21

X

FIG. 4

S3

11

25

26

27

X  Y

FIG. 5